# FASCICULE DE BREVET EUROPEEN

(11) **EP 3 011 590 B1**
(45) Date de publication et mention de la délivrance du brevet: **29.07.2020**
(21) Numéro de dépôt: 14736890.6
(22) Date de dépôt: 11.06.2014
(51) Int. Cl.: H01L 21/673, H01L 21/762

(54) **PROCÉDÉ DE FABRICATION D'UNE PLURALITÉ DE STRUCTURES**
VERFAHREN ZUR HERSTELLUNG EINER VIELZAHL VON STRUKTUREN
METHOD FOR PRODUCING A PLURALITY OF STRUCTURES

(30) Priorité: 18.06.2013 FR 1301437
(43) Date de publication de la demande: 27.04.2016
(73) Titulaire: Soitec, 38190 Bernin (FR)
(72) Inventeur: LANDRU, Didier, F-38190 Champ Pres Froges (FR); KONONCHUK, Oleg, F-38570 Theys (FR); GOURDEL, Christophe, F-38530 Saint Maximin (FR); DAVID, Carole, F-38920 Crolles (FR); MOUGEL, Sébastien, F-38700 Sarcenas (FR); SCHNEIDER, Xavier, F-38660 Le Touvet (FR)
(74) Mandataire: IP Trust
(86) Numéro de dépôt international: PCT/FR2014/051406
(87) Numéro de publication internationale: WO 2014/202866

(56) Documents cités:
- US-A1- 2008 095 678
- KONONCHUK O ET AL: "Novel Trends in SOI Technology for CMOS Applications", DIFFUSION AND DEFECT DATA. PART B: SOLID STATE PHENOMENA; GETTERING AND DEFECT ENGINEERING IN SEMICONDUCTOR TECHNOLOGY XIII : GADEST 2009 ; PROCEEDINGS OF THE 13TH INTERNATIONAL AUTUMN MEETING, DÖLLNSEE-SCHORFHEIDE, NORTH OF BERLIN, GERMANY, SEPTEMBE, vol. 156/158, 1 janvier 2010 (2010-01-01), pages 69-76, XP008165382, ISSN: 1012-0394
- KONONCHUK O ET AL: "Internal Dissolution of Buried Oxide in SOI Wafers", DIFFUSION AND DEFECT DATA. PART B: SOLID STATE PHENOMENA, SCITEC PUBLICATIONS LTD, CH, vol. 131-133, 1 janvier 2008 (2008-01-01), pages 113-118, XP009108625, ISSN: 1012-0394

## Description

La présente invention se rapporte à un procédé de fabrication d'une pluralité de structures comportant chacune successivement un substrat, un diélectrique comprenant un oxyde, et une couche active comprenant un matériau semi-conducteur.

Par « couche active », on entend une couche (ou une pluralité de sous-couches) sur laquelle ou dans laquelle seront fabriqués des composants destinés à des applications notamment dans les domaines de la microélectronique, l'optique, l'optoélectronique.

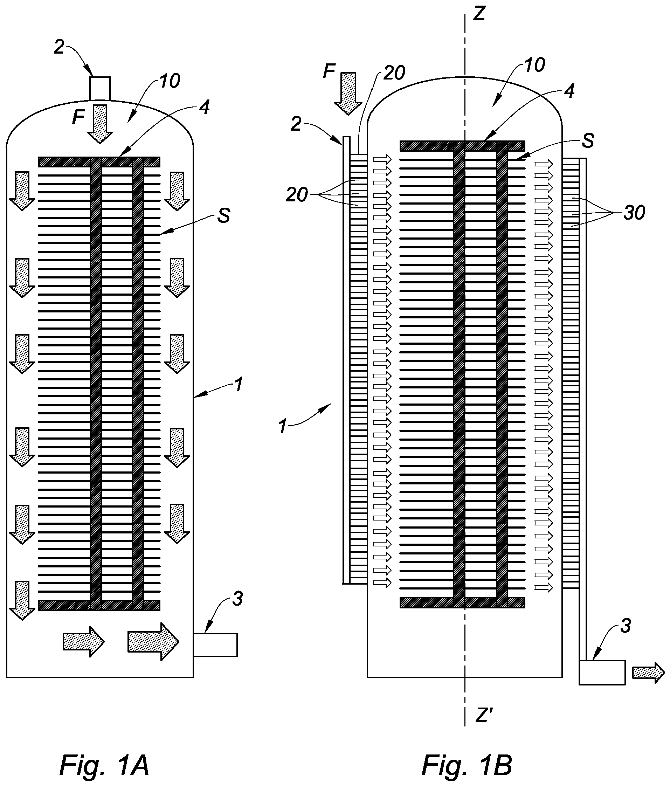

Un procédé de fabrication connu de l'état de la technique, illustré à la figure 1A, comporte les étapes :
a) fourniture d'une enceinte 10 adaptée pour recevoir la pluralité de structures S,
b) circulation d'un flux gazeux F (matérialisée par les flèches) dans l'enceinte 10 de sorte que l'enceinte 10 présente une atmosphère non oxydante,
c) traitement thermique de la pluralité de structures S à une température supérieure à une valeur seuil au-delà de laquelle l'oxygène présent dans l'oxyde du diélectrique diffuse à travers la couche active, réagit avec le matériau semi-conducteur de la couche active, et produit un matériau volatil.

L'enceinte fournie lors de l'étape a) appartient à un dispositif 1, et est équipée d'un système de support 4 adapté pour supporter les structures S.

L'atmosphère non oxydante peut être obtenue lors de l'étape b) par un flux gazeux F continu de gaz inerte (tel que de l'argon) ou réducteur. Par « non oxydante », on entend une atmosphère présentant une teneur en oxygène inférieure à 10 ppm. Le flux gazeux F est injecté dans l'enceinte 10 via l'entrée 2 et est évacué de l'enceinte 10 via la sortie 3.

Le traitement thermique est effectué lors de l'étape c) à haute température, classiquement de l'ordre de 1200 °C.

Il est à noter que les étapes b) et c) sont préférentiellement exécutées simultanément.

Un tel procédé de l'état de la technique est notamment employé lorsque le diélectrique comporte du dioxyde de silicium, et lorsque le matériau semi-conducteur de la couche active comporte du silicium. Le matériau volatil produit comporte alors du monoxyde de silicium. L'étape c) permet donc de dissoudre partiellement le diélectrique. Un tel procédé de l'état de la technique est particulièrement avantageux pour la fabrication de structures nécessitant une épaisseur de diélectrique inférieure à 200 nm.

L'homme du métier trouvera une description technique d'un tel procédé dans les articles de Kononchuk (Kononchuck et al., Novel trends in SOI technology for CMOS applications, Solid state Phenomena, Vols. 156-158 (2010) pp69-76, ainsi que Konochuck et al., Internai Dissolution of Buried Oxide in SOI Wafers, Solid State Phenomena, Vols. 131-133 (2008) pp113-118).

Toutefois, un tel procédé de l'état de la technique n'est pas entièrement satisfaisant dans la mesure où la demanderesse a constaté que la dissolution du diélectrique lors de l'étape c) n'est pas uniforme, ce qui conduit à une non uniformité de l'épaisseur du diélectrique dans la structure fabriquée. Cette non uniformité est d'autant plus pénalisante que l'épaisseur du diélectrique désirée est faible (par exemple inférieure à 20 nm ou 10 nm) et que le diamètre de la structure est importante (300 mm, 450 mm).

La présente invention vise à remédier à l'inconvénient précité et concerne un procédé de fabrication d'une pluralité de structures comportant chacune successivement un substrat, un diélectrique comprenant un oxyde, et une couche active comprenant un matériau semi-conducteur, le procédé comportant les étapes :
a) fourniture d'une enceinte adaptée pour recevoir la pluralité de structures,
b) circulation d'un flux gazeux dans l'enceinte de sorte que l'enceinte présente une atmosphère non oxydante,
c) traitement thermique de la pluralité de structures à une température supérieure à une valeur seuil au-delà de laquelle l'oxygène présent dans l'oxyde du diélectrique diffuse à travers la couche active, réagit avec le matériau semi-conducteur de la couche active, et produit un matériau volatil, le procédé étant remarquable en ce que les étapes b) et c) sont exécutées de sorte que le flux gazeux présente une vitesse de circulation entre la pluralité de structures, notée V_{f}, supérieure à la vitesse de diffusion du matériau volatil dans le flux gazeux, notée V_{d'} avec V_{f}/V_{d} ≥ 100.

La demanderesse a constaté que la non uniformité de la dissolution du diélectrique lors de l'étape c) est essentiellement due à une accumulation du matériau volatil au voisinage de la couche active plus importante au centre de la structure qu'aux bords de la structure. Il résulte de ce gradient de concentration du matériau volatil une surépaisseur du diélectrique au centre de la structure. En effet, la vitesse de circulation du flux gazeux entre la pluralité de structures est très faible relativement à la vitesse de diffusion du matériau volatil dans le flux gazeux ; typiquement V_{f}/V_{d} < 10. L'évacuation du matériau volatil s'effectue donc majoritairement par diffusion (à une vitesse de l'ordre du mm/s) vers les bords des structures. Le gradient de concentration du matériau volatil au voisinage de la couche active conduit ainsi à un ralentissement de la dissolution du diélectrique au centre des structures relativement aux bords des structures.

L'invention résout ce problème par un flux gazeux présentant une vitesse de circulation entre la pluralité de structures, notée V_{f}, supérieure à la vitesse de diffusion du matériau volatil dans le flux gazeux, notée V_{d}. Ainsi, le gradient de concentration du matériau volatil entre les structures est évité en créant une circulation forcée du matériau volatil, et la dissolution du diélectrique lors de l'étape c) est rendue uniforme, ce qui conduit à une uniformité de l'épaisseur du diélectrique dans les structures fabriquées.

Il est à noter que les étapes b) et c) sont préférentiellement exécutées simultanément.

Les étapes b) et c) sont exécutées de sorte que V_{f}/V_{d} ≥ 100, de préférence V_{f}/V_{d} ≥ 1000.

Ainsi, de tels rapports entre la vitesse de circulation du flux gazeux dans l'enceinte et la vitesse de diffusion du matériau volatil dans le flux gazeux conduisent à réduire drastiquement le gradient de concentration du matériau volatil au voisinage de la couche utile entre chaque structure.

Selon un mode de réalisation, l'étape b) est exécutée de sorte que le flux gazeux circule au voisinage de la couche active de chaque structure.

Ainsi, une circulation forcée du matériau volatil est créée entre la pluralité de structures.

Selon une forme d'exécution, l'enceinte fournie lors de l'étape a) s'étend suivant un axe longitudinal, l'étape b) comporte une injection du flux gazeux dans l'enceinte dirigée parallèlement à l'axe longitudinal, et l'étape a) comporte une étape consistant à équiper l'enceinte de moyens de guidage agencés pour guider le flux gazeux injecté au voisinage de la couche active de chaque structure, les moyens de guidage comportant préférentiellement des ailettes disposées sur le pourtour de l'enceinte.

Selon une variante d'exécution, l'enceinte fournie lors de l'étape a) s'étend suivant un axe longitudinal, l'étape b) comporte une injection du flux gazeux dans l'enceinte dirigée parallèlement à l'axe longitudinal, l'étape a) comporte une étape consistant à équiper l'enceinte d'organes de support agencés pour supporter la pluralité de structures, et les organes de support sont mobiles en rotation relativement à l'enceinte autour de l'axe longitudinal de sorte que le flux gazeux circule au voisinage de la couche active de chaque structure.

Selon une caractéristique, les organes de support d'une structure forment une hélice s'enroulant partiellement autour de l'axe longitudinal, chaque organe de support de la structure formant une pale de l'hélice.

Ainsi, de tels organes de support permettent de réduire drastiquement le gradient de concentration du matériau volatil au voisinage de la couche utile entre chaque structure par un brassage du flux gazeux.

Selon une variante d'exécution, l'enceinte fournie lors de l'étape a) s'étend suivant un axe longitudinal, et l'étape b) comporte une injection du flux gazeux dans l'enceinte dirigée perpendiculairement à l'axe longitudinal et orientée vers chaque structure de sorte que le flux gazeux circule au voisinage de la couche active de chaque structure.

Avantageusement, le procédé comporte une étape d'évacuation du flux gazeux circulant au voisinage de la couche active de chaque structure, l'évacuation du flux gazeux hors de l'enceinte étant dirigée perpendiculairement à l'axe longitudinal de l'enceinte.

Ainsi, une telle évacuation dédiée à chaque structure permet d'éviter un gradient de concentration du matériau volatil suivant l'axe longitudinal.

Selon une autre variante d'exécution, l'étape b) comporte une étape d'injection du flux gazeux dans l'enceinte dirigée au centre de chaque structure.

Ainsi, une circulation forcée du matériau volatil est créée du centre de la structure vers les bords de la structure, et ce afin d'éviter un gradient de concentration du matériau volatil au voisinage de la couche utile entre chaque structure.

Avantageusement, l'étape a) comporte une étape consistant à équiper l'enceinte d'organes de support agencés pour supporter la pluralité de structures, et les organes de support forment des conduits agencés pour guider le flux gazeux injecté au centre d'une structure.

Ainsi, de tels organes de support assurent une double fonction : le support des structures et l'injection du flux gazeux.

Selon un mode de réalisation, le procédé comporte une étape d'évacuation du flux gazeux hors de l'enceinte, et une partie du flux gazeux évacué est réinjecté dans l'enceinte.

Ainsi, la concentration de matériau volatil est homogénéisée le long de l'enceinte en plus de l'homogénéité de concentration entre le centre et les bords des structures.

Avantageusement, la couche active de chaque structure présente une surface libre, l'étape a) comporte une étape consistant à équiper l'enceinte de moyens de support agencés pour supporter la pluralité de structures, et le procédé comporte une étape de mise en mouvement de rotation des moyens de support autour d'un axe perpendiculaire à la surface libre de la couche active de chaque structure.

Ainsi, une telle mise en mouvement permet d'éviter une asymétrie du flux gazeux circulant au voisinage de la couche active de chaque structure.

Selon une forme d'exécution, le diélectrique comporte du dioxyde de silicium, le matériau semi-conducteur de la couche active comporte du silicium, et le matériau volatil produit comporte du monoxyde de silicium.

D'autres caractéristiques et avantages apparaîtront dans la description qui va suivre de modes de mise en œuvre d'un procédé de fabrication selon l'invention, donnés à titre d'exemples non limitatifs, en référence aux dessins annexés dans lesquels :
- la figure 1A (déjà commentée) est une vue en coupe longitudinale d'un dispositif pour mettre en œuvre un mode de réalisation selon l'état de la technique,
- la figure 1B est une vue en coupe longitudinale d'un dispositif pour mettre en œuvre un premier mode de réalisation de l'invention,
- la figure 2 est une vue en coupe transversale d'un dispositif pour mettre en œuvre un deuxième mode de réalisation de l'invention,
- la figure 3 est une vue en coupe longitudinale d'un dispositif pour mettre en œuvre le deuxième mode de réalisation de l'invention,
- la figure 4 est une vue en coupe transversale d'un dispositif pour mettre en œuvre un troisième mode de réalisation de l'invention,
- la figure 5 est une vue en coupe transversale d'un dispositif pour mettre en œuvre un quatrième mode de réalisation de l'invention.

Pour les différents modes de réalisation, les mêmes références seront utilisées pour des éléments identiques ou assurant la même fonction, par souci de simplification de la description.

Le dispositif 1 illustré à la figure 1B est un dispositif pour fabriquer une pluralité de structures S comportant chacune successivement un substrat, un diélectrique comprenant un oxyde, et une couche active comprenant un matériau semi-conducteur.

Le dispositif 1 comporte :
- une enceinte 10 adaptée pour recevoir la pluralité de structures S,
- des moyens de circulation d'un flux gazeux F dans l'enceinte 10 de sorte que l'enceinte 10 est susceptible de présenter une atmosphère non oxydante,
- des moyens de chauffage susceptibles de générer un traitement thermique de la pluralité de structures S à une température supérieure à une valeur seuil au-delà de laquelle l'oxygène présent dans l'oxyde du diélectrique diffuse à travers la couche active, réagit avec le matériau semi-conducteur de la couche active, et produit un matériau volatil.

Par « non oxydante », on entend une atmosphère présentant une teneur en oxygène inférieure à 10 ppm.

L'enceinte 10 est équipée d'un système de support 4 adapté pour supporter les structures S. L'enceinte 10 s'étend suivant un axe longitudinal Z'-Z vertical.

Les moyens de circulation comportent une pluralité de conduits d'injection 20 du flux gazeux dans l'enceinte 10. Les conduits d'injection 20 sont reliés entre eux par une entrée 2 du flux gazeux F. Chaque conduit d'injection 20 est dédié à une structure S. Les conduits d'injection 20 sont configurés pour que le flux gazeux F présente une vitesse de circulation entre les structures S, notée V_{f}, supérieure à la vitesse de diffusion du matériau volatil dans le flux gazeux F, notée V_{d}. Plus précisément, chaque conduit d'injection 20 peut présenter un diamètre inférieur à une valeur prédéterminée en deçà de laquelle V_{f}/V_{d} ≥ 100, de préférence V_{f}/V_{d} ≥ 1000. Le diamètre de chaque conduit d'injection 20 peut être constant, de préférence compris entre 0,5 mm et 1,5 mm, encore préférentiellement sensiblement égal à 1 mm. L'injection du flux gazeux F dans l'enceinte 10 est dirigée perpendiculairement à l'axe longitudinal Z'-Z et orientée vers chaque structure S de sorte que le flux gazeux F circule au voisinage de la couche active de chaque structure S.

Les moyens de circulation comportent une pluralité de conduits d'évacuation 30 du flux gazeux F hors de l'enceinte 10. La pluralité de conduits d'évacuation 30 est agencée en regard de la pluralité de conduits d'injection 20. Les conduits d'évacuation 30 sont reliés entre eux par une sortie 3 du flux gazeux F.

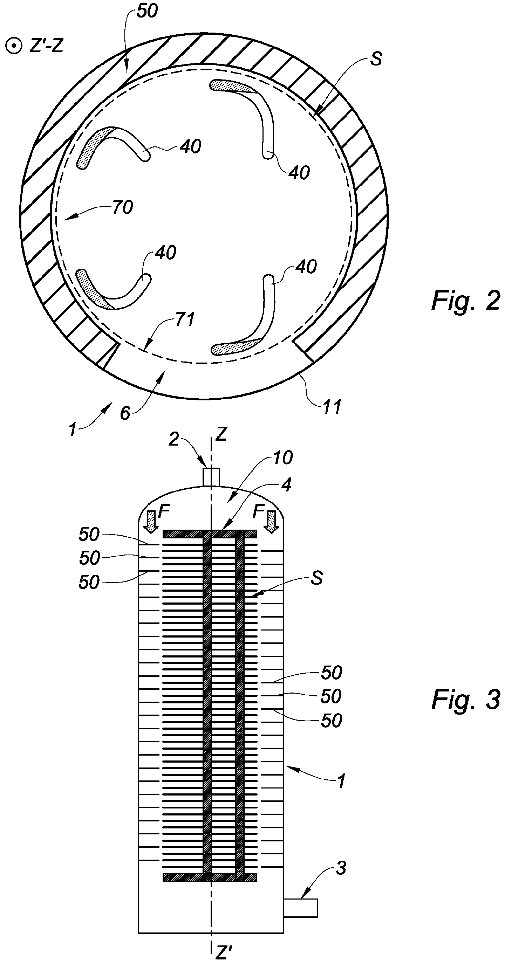

Dans le mode de réalisation illustré aux figures 2 et 3, le dispositif 1 diffère du dispositif illustré à la figure 1B en ce que :
- l'injection du flux gazeux F dans l'enceinte 10 est dirigée parallèlement à l'axe longitudinal Z'-Z,
- l'enceinte 10 est équipée de moyens de guidage agencés pour guider le flux gazeux F injecté au voisinage de la couche active de chaque structure S.

Les moyens de guidage comportent des ailettes 50 disposées sur le pourtour de l'enceinte 10. Les ailettes 50 s'étendent perpendiculairement à l'axe longitudinal Z'-Z et parallèlement aux structures S. Les ailettes 50 sont réparties le long de l'axe longitudinal Z'-Z de sorte que chaque ailette 50 est coplanaire à une structure S. Lorsqu'une structure S (en pointillés sur la figure 2) est supportée par les organes de support 40 appartenant au système de support 4, l'ailette 50 correspondante épouse une première partie 70 du pourtour de la structure S. L'ailette 50 correspondante délimite une ouverture 6 avec une seconde partie 71 du pourtour de la structure S et le carter 11 du dispositif 1. La circulation du flux gazeux F est ainsi forcée à travers l'ouverture 6. Les ailettes 50 sont agencées suivant l'axe longitudinal Z'-Z relativement aux structures S de sorte que le flux gazeux F circule au voisinage de la couche active de chaque structure S.

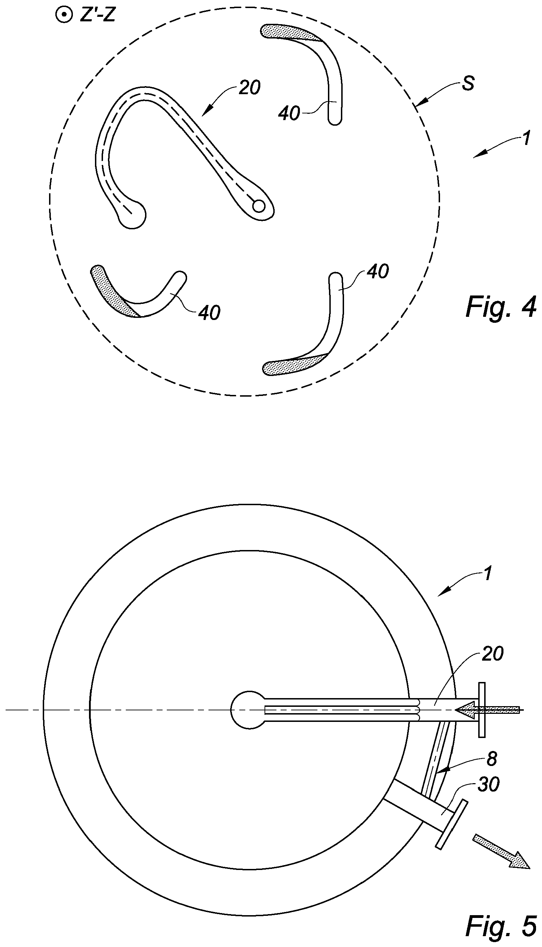

Dans le mode de réalisation illustré à la figure 4, le dispositif 1 diffère du dispositif illustré à la figure 1B et du dispositif illustré aux figures 2 et 3 en ce que les moyens de circulation comportent une pluralité de conduits d'injection 20 du flux gazeux F dans l'enceinte 10 dirigés au centre d'une structure S. Chaque conduit d'injection 20 forme des moyens de support de la structure S située au-dessus de la structure S au centre de laquelle est dirigé le conduit d'injection 20 correspondant. Les traits pointillés de la figure 4 illustrent l'injection du flux gazeux F.

Dans le mode de réalisation illustré à la figure 5, le dispositif 1 comporte un conduit d'évacuation 30 du flux gazeux F hors de l'enceinte 10. Le dispositif 1 comporte un canal de liaison 8 agencé pour relier un conduit d'injection 20 au conduit d'évacuation 30. Le canal de liaison 8 présente un diamètre suffisamment petit relativement aux diamètres du conduit d'injection 20 et du conduit d'évacuation 30 de manière à autoriser un effet Venturi.

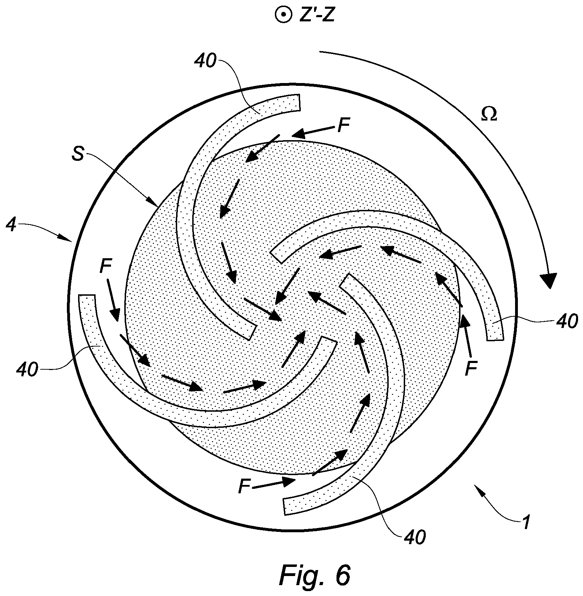

Dans le mode de réalisation illustré à la figure 6, le dispositif 1 diffère du dispositif 1 illustré aux figures 2 et 3 en ce que les organes de support 40 sont mobiles en rotation relativement à l'enceinte 10 autour de l'axe longitudinal Z'-Z (avec un sens de rotation Ω illustré à la figure 6) de sorte que le flux gazeux F circule au voisinage de la couche active de chaque structure S. Les organes de support 40 d'une structure S forment une hélice s'enroulant partiellement autour de l'axe longitudinal Z'-Z. Chaque organe de support 40 de la structure S correspondante forme une pale de l'hélice.

Selon un mode de mise en œuvre, un procédé selon l'invention est un procédé de fabrication d'une pluralité de structures S comportant chacune successivement un substrat, un diélectrique comprenant un oxyde, et une couche active comprenant un matériau semi-conducteur, le procédé comportant les étapes :
a) fourniture d'une enceinte 10 adaptée pour recevoir la pluralité de structures S,
b) circulation d'un flux gazeux F dans l'enceinte 10 de sorte que l'enceinte 10 présente une atmosphère non oxydante,
c) traitement thermique de la pluralité de structures S à une température supérieure à une valeur seuil au-delà de laquelle l'oxygène présent dans l'oxyde du diélectrique diffuse à travers la couche active, réagit avec le matériau semi-conducteur de la couche active, et produit un matériau volatil.

Les étapes b) et c) sont exécutées de sorte que le flux gazeux F présente une vitesse de circulation entre les structures S, notée V_{f}, supérieure à la vitesse de diffusion du matériau volatil dans le flux gazeux F, notée V_{d}. Les étapes b) et c) sont exécutées de sorte que V_{f}/V_{d} 100, de préférence V_{f}/V_{d} ≥ 1000. L'étape b) est exécutée de sorte que le flux gazeux F circule au voisinage de la couche active de chaque structure S. Le traitement thermique est effectué lors de l'étape c) à haute température, classiquement de l'ordre de 1200 °C. De manière avantageuse, le traitement thermique est effectué à une température supérieure à 1150°C et pendant une durée inférieure à 4 heures. Il peut s'agir par exemple d'un traitement thermique effectué à 1200°C pendant moins d'une heure, voire moins de 30 minutes; ou encore d'un traitement thermique effectué à 1175° pendant moins de 3 heures.

Selon un mode de mise en œuvre, l'enceinte 10 fournie lors de l'étape a) s'étend suivant un axe longitudinal Z'-Z. L'étape b) comporte une injection du flux gazeux F dans l'enceinte 10 dirigée parallèlement à l'axe longitudinal (voir figure 3). L'étape a) comporte une étape consistant à équiper l'enceinte 10 de moyens de guidage agencés pour guider le flux gazeux F injecté au voisinage de la couche active de chaque structure S. Les moyens de guidage comportent préférentiellement des ailettes 50 disposées sur le pourtour de l'enceinte 10. Comme illustré aux figures 2 et 3, Les ailettes 50 s'étendent perpendiculairement à l'axe longitudinal Z'-Z et parallèlement aux structures S. Les ailettes 50 sont réparties le long de l'axe longitudinal Z'-Z de sorte que chaque ailette 50 est coplanaire à une structure S. Lorsqu'une structure S (en pointillés sur la figure 2) est supportée par les organes de support 40 appartenant au système de support 4, l'ailette 50 correspondante épouse une première partie 70 du pourtour de la structure S. L'ailette 50 correspondante délimite une ouverture 6 avec une seconde partie 71 du pourtour de la structure S et le carter 11 du dispositif 1. La circulation du flux gazeux F est ainsi forcée à travers l'ouverture 6. Les ailettes 50 sont agencées suivant l'axe longitudinal Z'-Z relativement aux structures S de sorte que le flux gazeux F circule au voisinage de la couche active de chaque structure S.

Selon une variante de mise en œuvre illustré à la figure 1B, l'enceinte 10 fournie lors de l'étape a) s'étend suivant un axe longitudinal Z'-Z, et l'étape b) comporte une injection du flux gazeux F dans l'enceinte 10 via des conduits d'injection 20. Les conduits d'injection 20 sont reliés entre eux par une entrée 2 du flux gazeux F. L'injection est dirigée perpendiculairement à l'axe longitudinal Z'-Z et orientée vers chaque structure S de sorte que le flux gazeux F circule au voisinage de la couche active de chaque structure S.

Comme illustré à la figure 1B, le procédé comporte une étape d'évacuation du flux gazeux F circulant au voisinage de la couche active de chaque structure S via des conduits d'évacuation 30. L'évacuation du flux gazeux F hors de l'enceinte 10 est dirigée perpendiculairement à l'axe longitudinal Z'-Z. La pluralité de conduits d'évacuation 30 est agencée en regard de la pluralité de conduits d'injection 20. Les conduits d'évacuation 30 sont reliés entre eux par une sortie 3 du flux gazeux F.

Selon un mode de mise en œuvre illustré à la figure 4, l'étape b) comporte une étape d'injection du flux gazeux F dans l'enceinte 10 dirigée au centre de chaque structure S. L'étape a) comporte une étape consistant à équiper l'enceinte 10 d'organes de support 40 agencés pour supporter la pluralité de structures S. Au moins un organe de support 40 forme un conduit d'injection 20 agencé pour guider le flux gazeux F injecté au centre d'une structure S.

Selon un mode de mise en œuvre illustré à la figure 5, le procédé comporte une étape d'évacuation du flux gazeux F hors de l'enceinte 10 via un conduit d'évacuation 30. Une partie du flux gazeux F évacué est réinjecté dans l'enceinte 10 via un conduit d'injection 20. Un canal de liaison 8 est agencé pour relier le conduit d'injection 20 au conduit d'évacuation 30. Le canal de liaison 8 présente un diamètre suffisamment petit relativement aux diamètres du conduit d'injection 20 et du conduit d'évacuation 30 de manière à autoriser un effet Venturi.

Selon un mode de mise en œuvre non représenté, la couche active de chaque structure S présente une surface libre, et le procédé comporte une étape de mise en mouvement de rotation du système de support 4 de la pluralité de structures S autour d'un axe perpendiculaire à la surface libre de la couche active de chaque structure S. Ce mode de mise en œuvre est particulièrement avantageux en combinaison avec les modes de mise en œuvre illustrés aux figures 1B, 2, 3 et 6.

Selon un mode de mise en œuvre, le diélectrique comporte du dioxyde de silicium, le matériau semi-conducteur de la couche active comporte du silicium, et le matériau volatil produit comporte du monoxyde de silicium.

Bien entendu, les modes de réalisation de l'invention décrits ci-dessus ne présentent aucun caractère limitatif. Des détails et améliorations peuvent y être apportés dans d'autres variantes d'exécution dans le cadre de l'invention telle que revendiquée. C'est ainsi notamment que l'axe longitudinal Z'-Z peut être horizontal.

## Revendications

1. Procédé de fabrication d'une pluralité de structures (S) comportant chacune successivement un substrat, un diélectrique comprenant un oxyde, et une couche active comprenant un matériau semi-conducteur, le procédé comportant les étapes :
a) fourniture d'une enceinte (10) adaptée pour recevoir la pluralité de structures (S),
b) circulation d'un flux gazeux (F) dans l'enceinte (10) de sorte que l'enceinte (10) présente une atmosphère non oxydante,
c) traitement thermique de la pluralité de structures (S) à une température supérieure à une valeur seuil au-delà de laquelle l'oxygène présent dans l'oxyde du diélectrique diffuse à travers la couche active, réagit avec le matériau semi-conducteur de la couche active, et produit un matériau volatil,
le procédé étant **caractérisé en ce que** les étapes b) et c) sont exécutées de sorte que le flux gazeux (F) présente une vitesse de circulation entre la pluralité de structures (S), notée V_{f}, supérieure à la vitesse de diffusion du matériau volatil dans le flux gazeux, notée V_{d}, avec V_{f}/V_{d} ≥ 100.

2. Procédé selon la revendication 1, **caractérisé en ce que** les étapes b) et c) sont exécutées de sorte que V_{f}/V_{d} ≥ 1000.

3. Procédé selon la revendication 1 ou 2, **caractérisé en ce que** l'étape b) est exécutée de sorte que le flux gazeux (F) circule au voisinage de la couche active de chaque structure (S).

4. Procédé selon la revendication 3, **caractérisé en ce que** l'enceinte (10) fournie lors de l'étape a) s'étend suivant un axe longitudinal (Z'-Z), **en ce que** l'étape b) comporte une injection du flux gazeux (F) dans l'enceinte (10) dirigée parallèlement à l'axe longitudinal (Z'-Z), et **en ce que** l'étape a) comporte une étape consistant à équiper l'enceinte (10) de moyens de guidage agencés pour guider le flux gazeux (F) injecté au voisinage de la couche active de chaque structure (S), les moyens de guidage comportant préférentiellement des ailettes (50) disposées sur le pourtour de l'enceinte (10).

5. Procédé selon la revendication 3, **caractérisé en ce que** l'enceinte (10) fournie lors de l'étape a) s'étend suivant un axe longitudinal (Z'-Z), **en ce que** l'étape b) comporte une injection du flux gazeux (F) dans l'enceinte (10) dirigée parallèlement à l'axe longitudinal (Z'-Z), **en ce que** l'étape a) comporte une étape consistant à équiper l'enceinte (10) d'organes de support (40) agencés pour supporter la pluralité de structures (S), et **en ce que** les organes de support (40) sont mobiles en rotation relativement à l'enceinte (10) autour de l'axe longitudinal (Z'-Z) de sorte que le flux gazeux (F) circule au voisinage de la couche active de chaque structure (S).

6. Procédé selon la revendication 5, **caractérisé en ce que** les organes de support (40) d'une structure (S) forment une hélice s'enroulant partiellement autour de l'axe longitudinal (Z'-Z), chaque organe de support (40) de la structure (S) formant une pale de l'hélice.

7. Procédé selon la revendication 3, **caractérisé en ce que** l'enceinte (10) fournie lors de l'étape a) s'étend suivant un axe longitudinal (Z'-Z), et **en ce que** l'étape b) comporte une injection du flux gazeux (F) dans l'enceinte (10) dirigée perpendiculairement à l'axe longitudinal (Z'-Z) et orientée vers chaque structure (S) de sorte que le flux gazeux (F) circule au voisinage de la couche active de chaque structure (S).

8. Procédé selon la revendication 7, **caractérisé en ce qu'**il comporte une étape d'évacuation du flux gazeux (F) circulant au voisinage de la couche active de chaque structure (S), l'évacuation du flux gazeux (F) hors de l'enceinte (10) étant dirigée perpendiculairement à l'axe longitudinal (Z'-Z).

9. Procédé selon la revendication 3, **caractérisé en ce que** l'étape b) comporte une étape d'injection du flux gazeux (F) dans l'enceinte (10) dirigée au centre de chaque structure (S).

10. Procédé selon la revendication 9, **caractérisé en ce que** l'étape a) comporte une étape consistant à équiper l'enceinte (10) d'organes de support (40) agencés pour supporter la pluralité de structures (S), et **en ce que** les organes de support (40) forment des conduits (20) agencés pour guider le flux gazeux (F) injecté au centre d'une structure (S).

11. Procédé selon l'une des revendications 1 à 10, **caractérisé en ce qu'**il comporte une étape d'évacuation du flux gazeux (F) hors de l'enceinte (10), et **en ce qu'**une partie du flux gazeux (F) évacué est réinjecté dans l'enceinte (10).

12. Procédé selon l'une des revendications 1 à 11, **caractérisé en ce que** la couche active de chaque structure (S) présente une surface libre, **en ce que** l'étape a) comporte une étape consistant à équiper l'enceinte (10) de moyens de support agencés pour supporter la pluralité de structures (S), et **en ce que** le procédé comporte une étape de mise en mouvement de rotation des moyens de support autour d'un axe perpendiculaire à la surface libre de la couche active de chaque structure (S).

13. Procédé selon l'une des revendications 1 à 12, **caractérisé en ce que** le diélectrique comporte du dioxyde de silicium, **en ce que** le matériau semi-conducteur de la couche active comporte du silicium, et **en ce que** le matériau volatil produit comporte du monoxyde de silicium.

14. Procédé selon l'une des revendications 1 à 13, **caractérisé en ce que** le traitement thermique de la pluralité de structures est effectué à une température supérieure à 1150°C et pendant une durée inférieure à 4 heures.

## Patentansprüche

1. Verfahren zur Herstellung mehrerer Strukturen (S), die jeweils nacheinander ein Substrat, ein Dielektrikum mit einem Oxid und eine aktive Schicht mit einem Halbleitermaterial umfassen, wobei das Verfahren folgende Schritte umfasst:
a) Bereitstellen eines Gehäuses (10), das für die Aufnahme der mehreren Strukturen (S) geeignet ist,
b) Zirkulieren eines Gasstroms (F) durch das Gehäuse (10), so dass das Gehäuse (10) eine nichtoxidierende Atmosphäre aufweist,
c) Wärmebehandlung der mehreren Strukturen (S) bei einer Temperatur oberhalb eines Schwellenwertes, über welchem der im Oxid des Dielektrikums vorhandene Sauerstoff durch die aktive Schicht diffundiert, mit dem Halbleitermaterial der aktiven Schicht reagiert und ein flüchtiges Material erzeugt,
wobei das Verfahren **dadurch gekennzeichnet ist, dass** die Schritte b) und c) so ausgeführt werden, dass der Gasstrom (F) eine Strömungsgeschwindigkeit zwischen den mehreren Strukturen (S), bezeichnet mit V_{f}, aufweist, die größer ist als die Diffusionsgeschwindigkeit des flüchtigen Materials in dem Gasstrom, bezeichnet mit V_{d}, wobei V_{f}/V_{d} ≥ 100.

2. Verfahren nach Anspruch 1, **dadurch gekennzeichnet, dass** die Schritte b) und c) so durchgeführt werden, dass V_{f}/V_{d} ≥ 1000.

3. Verfahren nach Anspruch 1 oder 2, **dadurch gekennzeichnet, dass** Schritt b) so durchgeführt wird, dass der Gasstrom (F) in der Nähe der aktiven Schicht jeder Struktur (S) strömt.

4. Verfahren nach Anspruch 3, **dadurch gekennzeichnet, dass** sich das in Schritt a) vorgesehene Gehäuse (10) entlang einer Längsachse (Z'-Z) erstreckt, dass Schritt b) eine parallel zur Längsachse (Z'-Z) gerichtete Einleitung des Gasstroms (F) in das Gehäuse (10) umfasst, und dass Schritt a) einen Schritt umfasst, der darin besteht, das Gehäuse (10) mit Führungsmitteln auszurüsten, die so angeordnet sind, dass sie den eingeleiteten Gasstrom (F) in der Nähe der aktiven Schicht jeder Struktur (S) lenken, wobei die Führungsmittel vorzugsweise Rippen (50) umfassen, die am Umfang des Gehäuses (10) angeordnet sind.

5. Verfahren nach Anspruch 3, **dadurch gekennzeichnet, dass** sich das in Schritt a) vorgesehene Gehäuse (10) entlang einer Längsachse (Z'-Z) erstreckt, dass Schritt b) eine parallel zur Längsachse (Z'-Z) gerichtete Einleitung des Gasstroms (F) in das Gehäuse (10) umfasst, dass Schritt a) einen Schritt umfasst, der darin besteht, das Gehäuse (10) mit Tragelementen (40) auszurüsten, die so angeordnet sind, dass sie die mehreren Strukturen (S) tragen, und dass die Tragelemente (40) in Bezug auf das Gehäuse (10) um die Längsachse (Z'-Z) drehbar sind, so dass der Gasstrom (F) in der Nähe der aktiven Schicht jeder Struktur (S) zirkuliert.

6. Verfahren nach Anspruch 5, **dadurch gekennzeichnet, dass** die Tragelemente (40) einer Struktur (S) eine Wendel bilden, die sich teilweise um die Längsachse (Z'-Z) wickelt, wobei jedes Tragelement (40) der Struktur (S) eine Schaufel der Wendel bildet.

7. Verfahren nach Anspruch 3, **dadurch gekennzeichnet, dass** sich das in Schritt a) vorgesehene Gehäuse (10) entlang einer Längsachse (Z'-Z) erstreckt, und dass Schritt b) eine Einleitung des Gasstroms (F) in das Gehäuse (10) umfasst, die senkrecht zur Längsachse (Z'-Z) und auf jede Struktur (S) ausgerichtet ist, so dass der Gasstrom (F) in der Nähe der aktiven Schicht jeder Struktur (S) zirkuliert.

8. Verfahren nach Anspruch 7, **dadurch gekennzeichnet, dass** es einen Schritt der Ausleitung des Gasstroms (F) umfasst, der in der Nähe der aktiven Schicht jeder Struktur (S) zirkuliert, wobei die Ausleitung des Gasstroms (F) aus dem Gehäuse (10) senkrecht zur Längsachse (Z'-Z) gerichtet ist.

9. Verfahren nach Anspruch 3, **dadurch gekennzeichnet, dass** der Schritt b) einen Schritt des Einleitens des Gasstroms (F) in das Gehäuse (10) umfasst, der auf den Mittelpunkt jeder Struktur (S) gerichtet ist.

10. Verfahren nach Anspruch 9, **dadurch gekennzeichnet, dass** der Schritt a) einen Schritt umfasst, der darin besteht, das Gehäuse (10) mit Trägerelementen (40) auszurüsten, die so angeordnet sind, dass sie die mehreren Strukturen (S) tragen, und dass die Trägerelemente (40) Kanäle (20) bilden, die so angeordnet sind, dass sie den in der Mitte einer Struktur (S) eingeleiteten Gasstrom (F) lenken.

11. Verfahren nach einem der Ansprüche 1 bis 10, **dadurch gekennzeichnet, dass** es einen Schritt des Ausleitens des Gasstroms (F) aus dem Gehäuse (10) umfasst, und dass ein Teil des ausgeleiteten Gasstroms (F) wieder in das Gehäuse (10) eingeleitet wird.

12. Verfahren nach einem der Ansprüche 1 bis 11, **dadurch gekennzeichnet, dass** die aktive Schicht jeder Struktur (S) eine freie Oberfläche aufweist, dass der Schritt a) einen Schritt umfasst, der darin besteht, das Gehäuse (10) mit Trägermitteln auszustatten, die so angeordnet sind, dass sie die mehreren Strukturen (S) tragen, und dass das Verfahren einen Schritt umfasst, bei dem die Trägermittel in eine Drehbewegung um eine zur freien Oberfläche der aktiven Schicht jeder Struktur (S) senkrechte Achse versetzt werden.

13. Verfahren nach einem der Ansprüche 1 bis 12, **dadurch gekennzeichnet, dass** das Dielektrikum Siliciumdioxid umfasst, dass das Halbleitermaterial der aktiven Schicht Silicium umfasst, und dass das erzeugte flüchtige Material Siliciummonoxid umfasst.

14. Verfahren nach einem der Ansprüche 1 bis 13, **dadurch gekennzeichnet, dass** die Wärmebehandlung der mehreren Strukturen bei einer Temperatur über 1150 °C und für einen Zeitraum von weniger als 4 Stunden durchgeführt wird.

## Claims

1. Method for producing a plurality of structures (S) each successively comprising a substrate, a dielectric including an oxide, and an active layer including a semiconducting material, the method comprising the steps of:
a) supplying an enclosure (10) suitable for receiving the plurality of structures (S),
b) circulating a gas flow (F) in the enclosure (10) such that the enclosure (10) has a non-oxidizing atmosphere,
c) thermally treating the plurality of structures (S) at a temperature greater than a threshold value above which the oxygen present in the oxide of the dielectric diffuses through the active layer, reacts with the semiconducting material of the active layer, and produces a volatile material,
the method being **characterized in that** steps b) and c) are executed such that the gas flow (F) has a circulation speed, V_{f}, between the plurality of structures (S) that is greater than the diffusion speed, V_{d}, of the volatile material into the gas flow, where V_{f}/V_{d} ≥ 100.

2. Method according to claim 1, **characterized in that** steps b) and c) are executed such that V_{f}/V_{d} ≥ 1000.

3. Method according to either claim 1 or claim 2, **characterized in that** step b) is executed such that the gas flow (F) circulates in the vicinity of the active layer of each structure (S).

4. Method according to claim 3, **characterized in that** the enclosure (10) supplied during step a) extends along a longitudinal axis (Z'-Z), **in that** step b) comprises injecting the gas flow (F) into the enclosure (10) in a manner directed in parallel with the longitudinal axis (Z'-Z), and **in that** step a) comprises a step consisting of equipping the enclosure (10) with guide means arranged so as to guide the injected gas flow (F) to the vicinity of the active layer of each structure (S), the guide means preferably comprising fins (50) positioned around the periphery of the enclosure (10).

5. Method according to claim 3, **characterized in that** the enclosure (10) supplied during step a) extends along a longitudinal axis (Z'-Z), **in that** step b) comprises injecting the gas flow (F) into the enclosure (10) in a manner directed in parallel with the longitudinal axis (Z'-Z), **in that** step a) comprises a step consisting of equipping the enclosure (10) with support elements (40) arranged so as to support the plurality of structures (S), and **in that** the support elements (40) are rotatable relative to the enclosure (10) about the longitudinal axis (Z'-Z) such that the gas flow (F) circulates in the vicinity of the active layer of each structure (S).

6. Method according to claim 5, **characterized in that** the support elements (40) of a structure (S) form a helix winding partly around the longitudinal axis (Z'-Z), each support element (40) of the structure (S) forming a blade of the helix.

7. Method according to claim 3, **characterized in that** the enclosure (10) supplied during step a) extends along a longitudinal axis (Z'-Z), and **in that** step b) comprises injecting the gas flow (F) into the enclosure (10) in a manner directed perpendicularly to the longitudinal axis (Z'-Z) and oriented toward each structure (S) such that the gas flow (F) circulates in the vicinity of the active layer of each structure (S).

8. Method according to claim 7, **characterized in that** said method comprises a step of removing the gas flow (F) circulating in the vicinity of the active layer of each structure (S), the gas flow (F) being removed from the enclosure (10) in a manner directed perpendicularly to the longitudinal axis (Z'-Z).

9. Method according to claim 3, **characterized in that** step b) comprises a step of injecting the gas flow (F) into the enclosure (10) in a manner directed to the center of each structure (S).

10. Method according to claim 9, **characterized in that** step a) comprises a step consisting of equipping the enclosure (10) with support elements (40) arranged so as to support the plurality of structures (S), and **in that** the support elements (40) form ducts (20) arranged so as to guide the injected gas flow (F) to the center of a structure (S).

11. Method according to any of claims 1 to 10, **characterized in that** said method comprises a step of removing the gas flow (F) from the enclosure (10), and **in that** part of the removed gas flow (F) is re-injected into the enclosure (10).

12. Method according to any of claims 1 to 11, **characterized in that** the active layer of each structure (S) has a free surface, **in that** step a) comprises a step consisting of equipping the enclosure (10) with support means arranged so as to support the plurality of structures (S), and **in that** the method comprises a step of setting the support means into a rotational movement about an axis perpendicular to the free surface of the active layer of each structure (S).

13. Method according to any of claims 1 to 12, **characterized in that** the dielectric comprises silicon dioxide, **in that** the semiconducting material of the active layer comprises silicon, and **in that** the volatile material produced comprises silicon monoxide.

14. Method according to any of claims 1 to 13, **characterized in that** the plurality of structures is thermally treated at a temperature of above 1150°C and for a period of less than 4 hours.
